# EUROPEAN PATENT APPLICATION

(11) **EP 4 770 324 A1**
(43) Date of publication of application: **01.07.2026**
(21) Application number: 24223526.5
(22) Date of filing: 27.12.2024
(51) Int. Cl.: H10D 48/00, H10D 64/27, H10D 64/68, B82Y 10/00

(54) **IMPROVED GATE DIELECTRIC MULTILAYER FOR USE IN GATE-INDUCED QUANTUM DOT DEVICES**

(71) Applicant: Nederlandse Organisatie voor toegepast- natuurwetenschappelijk onderzoek TNO, 2595 DA 's-Gravenhage (NL)
(72) Inventor: The designation of the inventor has not yet been filed
(74) Representative: Nederlandsch Octrooibureau

(57) **Abstract**

A quantum dot device comprising a semiconductor region (102); a first gate dielectric layer (104) of low dielectric constant dielectric material, preferably silicon dioxide, adjacent to the semiconductor region (102); a second gate dielectric layer (106) of high dielectric constant dielectric material, preferably aluminium oxide, adjacent to the first layer of low dielectric constant dielectric material (104); and a third gate dielectric layer (108) of low dielectric constant dielectric material, preferably silicon dioxide, adjacent to the second gate dielectric layer (106); wherein a thickness of the second layer (106) is less than 80% of a combined thickness of the first layer (104), the second layer (106) and the third layer (108), and more preferably less than 50%, and the thickness of the first layer (104) is less than the thickness of the third layer (108). A gate disposed on the gate dielectric layers is configured to induce quantum dots in the semiconductor layer (102). The dielectric layer structure compensates for the unwanted fixed charges present at the interface between the semiconductor (102) and the first dielectric layer (104). The second dielectric layer may be a nanolaminate.

## Description

### FIELD OF THE INVENTION

The invention relates to a semiconductor gate oxide structure. The invention further relates to a method for manufacturing said semiconductor gate oxide structure.

### BACKGROUND OF THE INVENTION

Some kinds of quantum computing devices are based upon localizing and controlling the spin states of charge carriers, (e.g., electrons or holes) within semiconductor materials. The charge carriers exist either at the semiconductor interface with the gate oxide (e.g., Silicon Metal-Oxide-Semiconductor (Si-MOS) type device), or within a thin quantum well buried below the semiconductor interface (e.g., thin layers of strained silicon (Si) or germanium (Ge) positioned between thicker layers of silicon-germanium (Si₁₋ₓGeₓ) alloys type devices). For Si-MOS type devices, the charge carriers can be localized in the direction orthogonal to the wafer surface at the Si/SiO₂ interface by the application of an electric field from metal gates above the gate oxide. For quantum well devices, the charge carriers can be localized by energetic confinement within the thin (4-10 nanometer (nm)) strained Si or strained Ge layers, which reside about 20-50 nm below the gate oxide interface. There are many other known types of carrier confinement strategies based upon heterogeneous semiconductor material stacks. The electrons are confined laterally by voltages applied to fine metal gates, which create potential wells to localize the charge carriers in 2 dimensions; these fine metal gates also control the interactions between two neighboring confined charge carriers. All of these operations happen at cryogenic temperatures. Charged defects present within the gate oxide form a very important, often deleterious, part of the device operation.

If the defects have positive charge, this can create regions of unwanted accumulation of electrons which can participate in unwanted electrical leakage currents within devices based upon control of single electrons. Rather, it can be desirable for these devices to have defects of negative charge within the gate oxide because this will hinder the formation of accumulated electrons within the semiconductor. The consequence of this negative charge in the gate oxide is that a sufficiently positive potential needs to be applied to the fine metal gates in order to create the potential wells for the single electrons.

This materials strategy is already implemented in electron-based semiconductor devices by using gate oxides of Aluminium Oxide (Al₂O₃). At a microscopic level, all known Al₂O₃ layers of silicon and SiGe contain an underlayer of thin (0.1 to 3nm) of SiO₂ either as a result of native oxidation of the semiconductor surface, or as a result of oxide growth during the deposition of Al₂O₃. The SiOx/Al₂O₃ interface within the gate stack (e.g., the semiconductor or SiOx or Al₂O₃ or metal material stack) is known to have a negative charge as described in "Depletion-mode quantum dots in intrinsic silicon" by Amitonov, S. V., Spruijtenburg, P. C., Vervoort, M. W. S., van der Wiel, W. G. and Zwanenburg, F. A., published in Appl. Phys. Lett. 112, 023102 in 2018 (Amitonov), also in "Al2O3 surface passivation characterized on hydrophobic and hydrophilic c-Si by a combination of QSSPC, CV, XPS and FTIR" by Goverde, B. Vermang, A. Morato, J. John, J. Horzel, G. Meneghesso, and J. Poortmans, published in Energy Procedia, Volume 27, Pages 355-360 in 2012 (Goverde), and in "The negative fixed charge of atomic layer deposited aluminium oxide-a two-dimensional SiO2/AlOx interface effect" by D. Hiller, David Tröger, Matthias Grube, Dirk König, and Thomas Mikolajick, published in J. Phys. D: Appl. Phys. 54, 275304 in 2021 (Hiller2021).

While this negative charge is beneficial for electron devices, the Al₂O₃ has unwanted bulk properties. Specifically, there are voltage, frequency, and time dependent properties as observed in our own data, where the voltage-dependence is explained in "Wenger "Microscopic model for the nonlinear behavior of high-k metal-insulator-metal capacitors" by Ch. Wenger, G. Lupina, M. Lukosius, O. Seifarth, H.-J. Müssig, S. Pasko and Ch. Lohe, published in J. Appl. Phys., Volume 103, page 104103 in 2008 (Wenger), and the frequency and time dependencies are described for other materials in "Dielectric relaxation in hafnium oxide: A study of transient currents and admittance spectroscopy in HfO2 metal-insulator-metal devices" by C. Mannequin, P. Gonon, C. Vallée, A. Bsiesy, H. Grampeix, V. Jousseaume, published in J. Appl. Phys., Volume 110 (10), page 104108 in 2011 (Mannequin) and in "Anomalous dielectric properties of amorphous solids at low temperatures" by D.D. Osheroff, Sven Rogge, Douglas Natelson, published in Physica B: Condensed Matter, Volumes 219-220, pages 243-246 in 1996 (Osheroff). These unwanted bulk properties may cause device instabilities like drift and noise during cryogenic operation of the device.

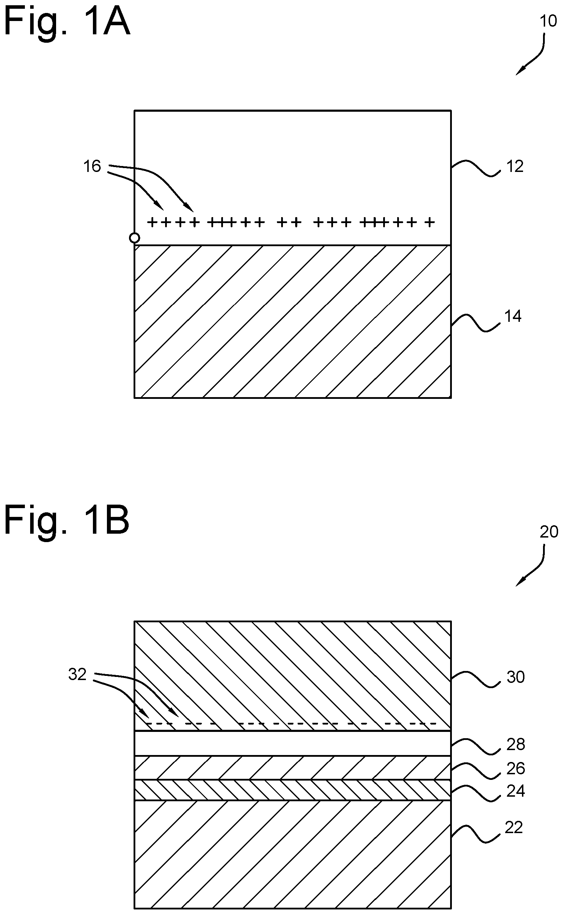

Most known charge-carrier spin-based semiconducting quantum devices have one of two types of gate oxides. One of those types of gate oxides are thermally grown oxide gates on silicon for SiMOS devices as shown in "Material and integration challenges for large scale Si quantum computing" by M. Vinet, T. Bédécarrats, B. Cardoso Paz, B. Martinez, E. Chanrion and E. Catapano, published in IEEE International Electron Devices Meeting in 2021 (Vinet) and in "Si MOS and Si/SiGe quantum well spin qubit platforms for scalable quantum computing" by R. Pillarisetty, T.F. Watson, B. Mueller, E. Henry, H.C. George and S. Bojarski, published in IEEE International Electron Devices Meeting (IEDM) in 2021 (Pillarisetty). This is shown in device 10 of Fig. 1A comprising a layer 12 of SiO₂ on top of a semiconductor region 14, wherein an interface region of positive charges 16 is typical formed; this can be undesirable for electron based devices.

The other type of gate oxides are deposited oxide gates, typically Al₂O₃, HfO₂ or SiO₂, on top of a native oxide on a heterostack (usually comprising SiGe alloys) as shown in "Universal control of a six-qubit quantum processor in silicon" by Stephan G. J. Philips, Mateusz T. M 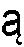 dzik, Sergey V. Amitonov, Sander L. de Snoo, Maximilian Russ, Nima Kalhor, Christian Volk, William I. L. Lawrie, Delphine Brousse, Larysa Tryputen, Brian Paquelet Wuetz, Amir Sammak, Menno Veldhorst, Giordano Scappucci and Lieven M. K. Vandersypen, published in Nature volume 609, pages 919-924 in 2022 (Philips) and also in Pillarisetty.

The interface of the thermal oxide on silicon is known to comprise a positive surface charge as disclosed in "Properties of the interface charge inhomogeneities in the thermally grown Si-Si02 structure", by K. Ziegler and E. Klausmann, published in Appl. Phys. Lett. 28, 678-681, in 1976 (Ziegler). ALD deposited SiO₂ films have also been shown to comprise a positive charge. This could be a disadvantage for certain kind of devices, for instance for devices based upon electron spins, because the positive charge leads to the accumulation of electrons in unwanted locations of the device at the surface during device operation. These regions can lead to surface leakage currents that are bad for the device operation.

As disclosed in Goverde and Simon and Hiller 2021shown in Fig. 1B, which discloses a device 20 with stacked layer 22 of semiconductor alloy, layer 24 of strained Si or Ge, layer 26 of semiconductor alloy, layer 28 of native SiO₂, and layer 30 of high-k dielectric material; when the layer 30 is comprised of Al₂O₃ and is in contact with the layer 28 of SiO₂, a layer of negative charge 32 is formed, and this can be used to repel electrons (or enhance holes) from the surface as shown in Amitonov. This layer of negative charge is also exploited in solar energy devices to reduce electron/hole recombination across interface trap states - the charge in the dielectric produces an electric field in the near surface region of the solar cells which helps to separate photogenerated charge carriers. While the surface charge can be desirable for charge carrier density control away from metal contacts, the bulk properties of Al₂O₃ are expected to not be ideal for spin qubit devices due to the voltage, frequency, and time dependences of the dielectric constant, as observed in our own capacitance measurements as well as those of Wenger, Mannquin, and Osheroff.

In view of this, there is a need to provide an improved semiconductor gate oxide structure.

### SUMMARY OF THE INVENTION

There is a need to provide semiconductor gate oxide structure that minimizes the volume of high-k material, thereby minimizing the voltage, frequency, and time dependence of the gate stack, while still having sufficient higher-k material to form a layer of controlled interface charge.

According to a first aspect of the invention it is provided a semiconductor structure for a quantum device, the semiconductor structure comprising a semiconductor region; a first layer of low dielectric constant dielectric material adjacent to the semiconductor region; a second layer of high dielectric constant dielectric material adjacent to the first layer of low dielectric constant dielectric material; and a third layer of low dielectric constant dielectric material; wherein a thickness of the second layer is less than 80% of a combined thickness of the first layer, the second layer and the third layer, and more preferably less than 50%, and the thickness of the first layer is less than the thickness of the third layer.

This allows to make a gate oxide dielectric stack that provides a high density of controlled surface charge (positive or negative depending upon the material and condition) while minimizing the volume of high-k material which is known to have voltage, frequency, and time dependent capacitance values. This is very advantageous for applications that wherein voltage, frequency, and/or time dependent capacitance values are generally undesired such as for some spin qubit devices.

The semiconductor structure may comprise a gate metal structure adjacent to the third layer. This provides a compact gate oxide dielectric stack that reduces unwanted charge carrier accumulation in regions of the semiconductor while also providing improved bulk dielectric properties. This is especially useful for semiconductor devices used in quantum computing applications. The third layer may be adjacent to the second layer.

The first layer may comprise thermally grown silicon dioxide. This allows for a low density of interface traps (D_{IT}) to be present at the interface of the semiconductor region that is closer to the first layer. However, this is a non-limiting embodiment and the first layer may comprise SiOz deposited by atomic layer deposition (ALD), plasma-enhanced atomic layer deposition (PE-ALD), chemical vapor deposition (CVD), plasma-enhanced chemical vapor deposition (PE-CVD), or sputtering. Alternatively, the first layer may comprise any other suitable low k material or combination thereof deposited or grown by any conventional method.

The thickness of the first layer may be between 0.1 nanometres and 5 nanometres. This is a suitable range to provide the advantages that have been previously described.

The second layer may comprise aluminum oxide. This is suitable high k material for electron based devices. Again, any other suitable high k material or combination thereof may be used for the second layer. Specifically different high-k materials may generate positive fixed charges with the dielectric, which can be of benefit for hole-based devices containing, for example, a germanium (Ge) quantum well, or certain types of fully-depleted silicon on insulator (FD-SOI) devices. A given device could have two or more different compositions of dielectric layers each localized to a different specific regions where there might be qubits comprised of either electrons or holes.

The thickness of the second layer may also be between 0.1 nanometres and 5 nanometres. This is also a suitable range to provide the advantages that have been previously described.

The third layer may comprise silicon dioxide. This is suitable low k material. Again, any other suitable low k material or combination thereof may be used for the second layer.

The thickness of the third layer may be between 3 nanometres and 30 nanometres. Once more, this is a suitable range to provide the advantages that have been previously described.

The second layer may be configured to form a stable layer of negative charge close to the first layer.

In an alternative embodiment, the second layer may be configured to form a stable layer of positive charge close to the first layer.

In an alternative embodiment, the second layer might comprise one material in one region to form a stable layer of negative charge close to the first layer and the second layer might comprise a different material in a second region to form a stable layer of positive charge close to the first layer.

The first layer and the third layer may comprise a material with a dielectric constant k of less than 5. The second layer may comprise a material with a dielectric constant k of more than 5.

The semiconductor gate oxide may comprise a nanolaminate structure between the second and the third layer, wherein the nanolaminate structure may comprise alternating layers of high dielectric constant dielectric material and low dielectric constant dielectric material. Such a structure could better allow for control over all the charges in the system (including the upper low-k material of the third layer). This is especially advantageous for semiconductor devices used for quantum computing applications as it allows to minimize unwanted charge carrier accumulation in the semiconductor region while also providing the best bulk dielectric properties of the device.

A total volume fraction of the high dielectric constant dielectric material in the nanolaminate structure may be less than 60%. In this way, the deleterious properties of the high-k material are reduced, which is especially advantageous for semiconductor devices used for quantum computing applications as it allows to further minimize unwanted charge carrier accumulation in the semiconductor region while also providing the best total bulk dielectric properties possible. Typically, in electronic devices, the goal is to minimize low-k material such that the electrical thickness (t/k) is as small as possible. For these applications thin thicknesses of high-k materials are typically used, and low-k materials are generally no longer desired for such applications.

The nanolaminate structure may comprise at least three layers of the high dielectric constant dielectric material and/or at least three layers of the low dielectric constant dielectric material. However, the nanolaminate structure may comprise any other number of layers of the high dielectric constant dielectric material and/or low dielectric constant dielectric material.

The semiconductor structure may be configured to operate at cryogenic temperatures. This provides advantages for certain applications, such as some quantum computing applications.

According to a second aspect of the invention, a method for manufacturing a semiconductor structure is disclosed, the method comprising providing a semiconductor substrate, forming a first layer of low dielectric constant dielectric material on the semiconductor substrate, forming a second layer of high dielectric constant dielectric material over the first layer; and forming a third layer of low dielectric constant dielectric material, wherein a thickness of the second layer is less than 80% of a combined thickness of the first layer, the second layer and the third layer, and more preferably less than 50%, and the thickness of the first layer is less than the thickness of the third layer.

### BRIEF DESCRIPTION OF THE DRAWINGS

The invention will be described further with respect to embodiments shown in the drawings.
FIGs. 1A-1B show schematically semiconductor structures according to the prior art.
FIG. 2 shows schematically a semiconductor structure according to an embodiment of the invention.
FIG 3 shows schematically a semiconductor structure according to another embodiment of the invention.
FIG. 4 illustrates a flow chart of a method a method for manufacturing a semiconductor structure according to an embodiment of the invention.

### DESCRIPTION

The following is a description of certain embodiments of the invention, given by way of example only and with reference to the figures. It is also to be understood that the terminology used herein is for the purpose of describing particular aspects only and is not intended to be limiting.

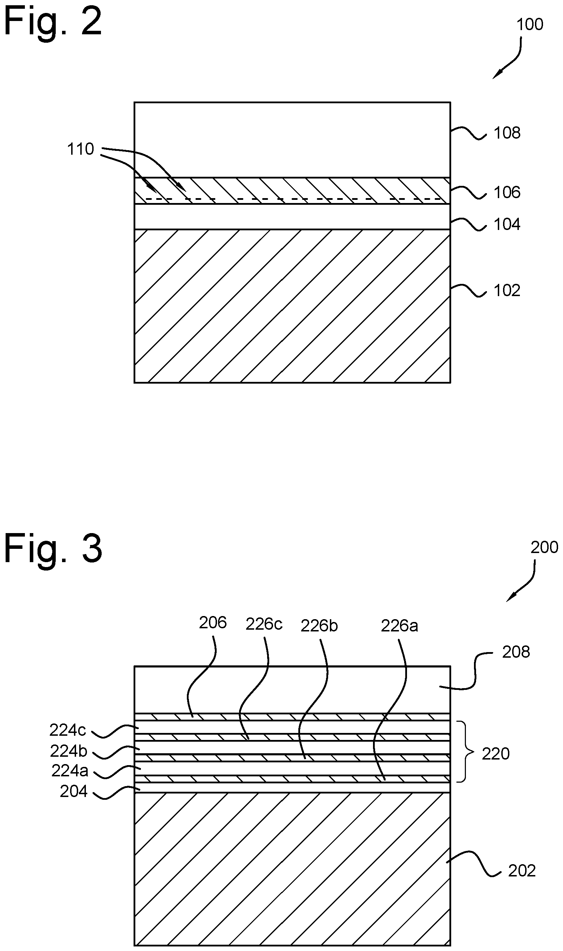

Fig. 2 shows a schematic of a semiconductor structure 100 for a quantum device comprising a semiconductor region 102, a first layer 104 of low dielectric constant dielectric material, a second layer 106 of high dielectric constant dielectric material, and a third layer 108 of low dielectric constant dielectric material. The first layer 104 of Figure 2 is formed on top of the semiconductor region 102, the second layer 106 is formed on top of the first layer 104 and the third layer 108 is formed on top of the second layer 104 such that the semiconductor structure 100 forms a stack structure. In Figure 2, a thickness of the second layer 106 is less than 80% of a combined thickness of the first layer 104, the second layer 106 and the third layer 108, while a thickness of the first layer 104 is less than the thickness of the third layer 108.

The semiconductor region 102 of Fig. 2 comprises thermal silicon dioxide (SiO₂). As said, this facilitates forming an interface between semiconductor region 102 and first layer 104 that has a low density of interface traps (D_{IT}). However, this is a non-limiting embodiment and the semiconductor region 102 may comprise SiOz deposited by atomic layer deposition (ALD) or any other suitable material and/or suitable combination of materials. The first layer 104 and/or the third layer 108 may comprise SiOz. The second layer 106 may comprise aluminium oxide (Al₂O₃).

The first layer 104 and/or the third layer 108 of Fig. 2 may comprise a material with a dielectric constant k of less than 5. The second layer 106 of Fig. 2 may comprise a material with a dielectric constant k greater than 5.

Although not shown in Fig. 2, the semiconductor structure 100 may further comprise a gate metal structure adjacent to the third layer 108. For instance, the gate metal structure may be on top of the third layer 108, that is, on the surface of the third layer 108 which is opposite to the surface of the third layer 108 that is adjacent to the second layer.

In Fig. 2, a thickness of the first layer 104 is between 0.1 nanometres and 5 nanometres (nm), a thickness of the second layer 106 is between 0.1 nm and 5 nm, and a thickness of the third layer 108 is between 3 nm and 30 nm. The second layer 106 of Fig. 2 forms a stable layer of negative charge 110 close to the first layer 104. In an alternative embodiment, the second layer 106 of Fig. 2 may form a stable layer of positive charge close to the first layer 104 instead of a stable layer of positive charge. In an alternate embodiment, there may be second layers comprised of 2 different materials in 2 different locations to facilitate the presence of different charge-carrier species in these different regions.

The semiconductor structure 100 may be configured to operate at cryogenic temperatures.

This allows to separate functionalities because a second charge-stabilizing layer 106 (typically having a high dielectric constant such as, for instance, Al₂O₃, or any other suitable material) is provided close to the surface of the semiconductor region 102 and covered by a third layer 108 which is made of a dielectric material having a lower dielectric constant and/or more importantly a lower voltage-, frequency-, and/or time-dependence to the dielectric constant than the material of the second layer 106. For instance, the third layer 108 may be made of SiO₂, or other suitable low-k material, having better bulk dielectric properties. This is especially advantageous when providing a gate stack customized specifically for electron-based spin qubit devices. But also, for other applications with similar requirements. The second layer 106 needs to be closer to the semiconductor region 102 than to the gate metal, and the low-k material should be present on both sides of the second layer 106. The first layer 104 may comprise SiOx, as having said material between the semiconductor region 102 and the high-k second layer 106 provides an advantage for the formation of desired fixed charge.

By keeping a thin second layer 106 of high-k material (e.g., Al2O3) between the two first and second layers 104 and 108 of low-k material (e.g. SiO₂), the above-described advantages are obtained. A first layer 104 of SiOz is generally formed in many cases and is often impossible to avoid during ALD deposition of the Al₂O₃ second layer 106 even on hydrogen-terminated (oxide-free) silicon substrates.

A minimum thickness of the first layer 104 of SiOz is desired so that the negative charge can be formed with a sufficient electrostatic barrier to avoid draining of such charge back to the silicon substrate region 102 under normal operating conditions.

The thickness of the second layer 106 of Al₂O₃ is desired to the be thin enough (to minimize the deleterious bulk properties) but still thick enough to form a stable layer of negative charge.

On top of that, a reasonable thickness of dielectric with good bulk qualities (generally low-k films like SiO₂ or carbon doped oxides) should be added as the third layer 108. These low-k films forming the third layer may be deposited by ALD, Plasma-Enhanced ALD (PEALD), Chemical Vapour Deposition (CVD), or Plasma-Enhanced CVD (PECVD). The thickness of the third layer 108 is desired to be in the range of 3 to 20 nm thickness.

The charge in the second layer 106 within the Al₂O₃ should be closer to the semiconductor region 102 than to the gate on the third layer 108 so that a significant number of electrical field lines from the charge go into the semiconductor region 102 rather than terminate in the upper metal electrode of the gate. For this reason, the third layer 108 is ideally thicker than the combination of the first and second layers 104 and 106. However, this is not a strict requirement as some electric field termination in the metal is acceptable as long as there is sufficient charge in the second layer to prevent spontaneous accumulation of unwanted charge carriers in the semiconductor 102.

The third layer 108 of low-k material should not be too thick otherwise the gate action of the metal on top of the third layer 108 to the carriers within the semiconductor 102 could be reduced below desired levels. A thickness for the third layer 108 in the range of 3 to 20nm may provide further advantageous in this respect. Thought the third layer may have any other suitable thickness.

Fig. 3 shows schematically a semiconductor device 200 comprising a nanolaminate structure 220 between the second 206 and the third layer 208. The nanolaminate structure 220 comprises alternating layers of high dielectric constant dielectric material 224 and low dielectric constant dielectric material 226.

Similarly to the semiconductor structure 100 of Fig. 2, the semiconductor structure 200 of Fig. 3 comprises a semiconductor region 202, a first layer 204 of low dielectric constant dielectric material with good properties, a second layer 206 of high dielectric constant dielectric material as needed to form a stable charged layer, and a third layer 208 of low dielectric constant dielectric material with good properties. The first layer 204 of Figure 3 is formed on top of the semiconductor region 202, the nanolaminate structure 220 is formed on top of the first layer 204, the second layer 206 is formed on top of the nanolaminate structure 220 and the third layer 208 is formed on top of the second layer 206 such that the semiconductor structure 200 forms a stack structure. In Figure 3, a combined thickness of the first layer 204 and the third layer 208 is greater than a thickness of the second layer 206, while a thickness of the first layer 204 is less than the thickness of the third layer 208.

The semiconductor region 202, the first layer 204 and/or the third layer 208 of Fig. 3 may comprise SiOz. The second layer 206 of Fig. 3 may comprise Al₂O₃.

The first layer 204 and/or the third layer 208 of Fig. 3 may comprise a material with a dielectric constant k of less than 5. The second layer 206 of Fig. 3 may comprise a material with a dielectric constant k greater than 5.

Although not shown in Fig. 3, the semiconductor structure 200 may further comprise a gate metal structure adjacent to the side of the third layer 208 that is opposite side to the second layer 206.

In Fig. 3, a thickness of the first layer 204 is between 0.1 nanometres and 5 nanometres (nm), a thickness of the second layer 206 is between 0.1 nm and 5 nm, and a thickness of the third layer 208 is between 3 nm and 30 nm. The second layer 206 of Fig. 3 forms a stable layer of negative charge (not shown). In an alternative embodiment, the second layer 206 of Fig. 3 may form a stable layer of positive charge instead of a stable layer of positive charge. In a further embodiment, the second layer 206 may comprises two spatially separate regions such that one region contains positive charge and the other region contains negative charge.

The nanolaminate structure 220 of Fig. 3 comprises three layers 226a, 226b and 226c of the high dielectric constant dielectric material and three layers 224a, 224b and 224c of the low dielectric constant dielectric material. However, the nanolaminate structure 220 may comprise any other suitable number of alternating layers 226 and layers 224.

A total volume fraction of the high dielectric constant dielectric material in the nanolaminate structure 200 of Fig. 3 may be less than 80%, preferably less than 60%. That is, the combined thickness of the second layer 206 and the three alternating layers 226a, 226b and 226c of high k material of the nanolaminate structure 220 may be less than 80% of the total thickness of the nanolaminate structure 220 of Fig. 3, and preferably less than 60%.

The semiconductor structure 200 of Fig. 3 may be configured to operate at cryogenic temperatures.

The nanolaminate structure may comprise first alternating layer 226a of low k material on top of the second layer 204 of high k material, second alternating layer 224a of high k material on top of the first alternating layer 226a, third alternating layer 226b of low k material on top of the second alternating layer 224a, fourth alternating layer 224b of high k material on top of the third alternating layer 226a, fifth alternating layer 226c of low k material on top of the fourth alternating layer 224b and sixth alternating layer 224c of high k material on top of the fifth alternating layer 226c.

The first alternating layer 226a, the third alternating layer 226b and fifth alternating layer 226c may be made of SiOz and the second alternating layer 224a, the fourth alternating layer 224b and sixth alternating layer 224c may be made of Al₂O₃. The total volume of Al₂O₃ in the semiconductor structure 200, preferably less than 50%.

In standard CMOS devices, usually it is desired to have the gate as absolutely electrically thin as possible (highest k possible) to minimize needed voltage at the gate to control the device. In this way, the high k layer closer to the gate is usually made of HfOx. Along with achieving the highest gate capacitance for CMOS, there is a desire to make all of the layers as thin and high-k as possible.

For quantum devices a reasonably thick low-k material with higher dielectric quality is desired as the third layer 108 and 208. For the devices 100 and 200, the requirements on gate capacitance are lower than for most of CMOS devices and what is required are good dielectric properties while at the same time having some level of Vt control at the gate. In quantum applications it is desired to minimize the overall volume of the lower quality high-k in the stack. The high-k second layer 106 according to the invention may be as thin as possible to minimize volume contribution, but the total low-k material may be thick to dilute the contribution of the high-k needed for the Vt shift.

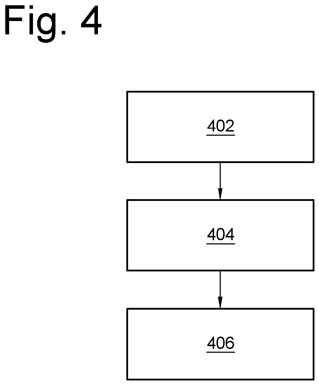

Fig. 4 shows a flowchart of a method for manufacturing a semiconductor structure according to an embodiment of the invention. The method of Fig. 4 comprises a step 402 of providing a semiconductor substrate. The method of Fig. 4 proceeds then to step 404 which comprises forming a first layer of low dielectric constant dielectric material on the semiconductor substrate. After step 404, the method of Fig. 4 goes to step 406 to form a second layer of high dielectric constant dielectric material over the first layer. Finally, the method of Fig. 4 proceeds to step 408 wherein a third layer of low dielectric constant dielectric material is formed. In the method 4, a thickness of the second layer is less than 80% of a combined thickness of the first layer, the second layer and the third layer, and more preferably less than 50%, and the thickness of the first layer formed in step 402 is less than the thickness of the third layer formed in step 408.

The method of Fig. 4 may comprise also a step of forming a gate on top of the third layer 108 after step 408. The method of Fig. 4 may be used to manufacture the semiconductor structure 100 of Fig. 2.

Alternatively, the method of Fig. 4 may comprise an intermediate step 405 performed between steps 404 and 406 and comprising forming a nanolaminated structure of alternating layers of high dielectric constant dielectric material and low dielectric constant dielectric material. In this way, the method of Fig. 4 may be used to manufacture the semiconductor structure 200 of Fig. 3.

Any of the steps 404, 405, 406 and 408 of method 4 may be performed using atomic-layer deposition techniques. For instance, by using an atomic-layer deposition technique in step 405, the alternated layers of the nanolaminated structure can be deposited all in one process. For instance, if the nanolaminated structure comprises 3 layers of SiO₂ and 3 layers of Al₂O₃, those layers may be deposit using an atomic-layer deposition technique in a single process. Furthermore, step 408 of forming the third layer of low k material may comprise depositing the low k material using a PECVD or CVD tool.

In a further embodiment, the semiconductor structure 100 or 200 may comprise two spatially separate regions within the second layer such that one region contains positive charge and the other region contains negative charge.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiments disclosed, but that the invention will include all embodiments falling within the scope of the appended claims.

## Claims

1. A semiconductor structure (100; 200) for a quantum device, the semiconductor structure comprising:
- a semiconductor region (102; 202);
- a first layer (104; 204a) of dielectric material having a low dielectric constant adjacent to the semiconductor region;
- a second layer (106; 206a) of dielectric material having a high dielectric constant adjacent to the first layer (104; 204a) of low dielectric constant dielectric material; and
- a third layer (108; 208) of dielectric material having a low dielectric constant;
wherein a thickness of the second layer (106; 206a) is less than 80% of a combined thickness of the first layer (104; 204a), the second layer and the third layer (108; 208), preferably the thickness of the second layer (106; 206a) is less than half of the combined thickness of the first layer (104; 204a), the second layer and the third layer (108; 208); and
wherein the thickness of the first layer (104; 204a) is less than the thickness of the third layer (108; 208).

2. The semiconductor structure (100; 200) according to claim 1, further comprising a gate metal structure adjacent to the third layer (108; 208) on a side opposite to the second layer.

3. The semiconductor structure (100) according to any of the previous claims, wherein the third layer (108) is adjacent to the second layer (106).

4. The semiconductor structure (100; 200) according to any of the previous claims, wherein the first layer (104; 204) comprises silicon dioxide.

5. The semiconductor structure (100; 200) according to any of the previous claims, wherein the second layer (106; 206) comprises aluminum oxide.

6. The semiconductor structure (100; 200) according to any of the previous claims, wherein the third layer (108; 208) comprises silicon dioxide.

7. The semiconductor structure (100; 200) according to any of the previous claims, wherein a thickness of the first layer is between 0.1 nanometres and 5 nanometres.

8. The semiconductor structure (100; 200) according to any of the previous claims, wherein a thickness of the second layer is between 0.1 nanometres and 5 nanometres.

9. The semiconductor structure (100; 200) according to any of the previous claims, wherein a thickness of the third layer is between 3 nanometres and 30 nanometres.

10. The semiconductor structure (100; 200) according to any of the previous claims, wherein the second layer is configured to form a stable layer of negative charge close to the first layer or wherein the second layer is configured to form a stable layer of positive charge close to the first layer or wherein the second layer comprises a first region and a second region and is configured to form a stable layer of negative charge in the first region and a stable layer of positive charge in the second region.

11. The semiconductor structure (200) of claim 1, further comprising a nanolaminate structure between the second (206a) and the third layer (208), wherein the nanolaminate structure comprises alternating layers of high dielectric constant dielectric material and low dielectric constant dielectric material.

12. The semiconductor structure (200) of claim 11, wherein a total volume fraction of the high dielectric constant dielectric material in the nanolaminate structure is less than 80%.

13. The semiconductor structure (200) of claim 11, wherein the nanolaminate structure comprises at least three layers of the high dielectric constant dielectric material.

14. The semiconductor structure (100; 200) of claim 1, further configured to operate at cryogenic temperatures.

15. A method for manufacturing a semiconductor structure (100; 200), the method comprising:
- providing (402) a semiconductor substrate;
- forming (404) a first layer of low dielectric constant dielectric material on the semiconductor substrate;
- forming (408) a second layer of high dielectric constant dielectric material over the first layer; and
- forming (410) a third layer of low dielectric constant dielectric material;
- wherein a thickness of the second layer (106; 206a) is less than 80% of a combined thickness of the first layer (104; 204a), the second layer and the third layer (108; 208), preferably the thickness of the second layer (106; 206a) is less than half of the combined thickness of the first layer (104; 204a), the second layer and the third layer (108; 208), and wherein the thickness of the first layer is less than the thickness of the third layer.
